# EUROPEAN PATENT APPLICATION

(11) **EP 4 239 355 A1**
(43) Date of publication of application: **06.09.2023**
(21) Application number: 22159452.6
(22) Date of filing: 01.03.2022
(51) Int. Cl.: G01R 33/3873

(54) **SHIM ELEMENTS FOR USE WITH A MAGNETIC RESONANCE APPARATUS**

(71) Applicant: Koninklijke Philips N.V., 5656 AG Eindhoven (NL)
(72) Inventor: FORTHMANN, Peter, Eindhoven (NL); MULDER, Gerardus Bernardus Jozef, Eindhoven (NL)
(74) Representative: Philips Intellectual Property & Standards

(57) **Abstract**

The invention relates to shim elements (100, ..., 115) for magnetic resonance applications. According to the invention, the shim elements (100, ...,115) comprise shim blocks (101, ...,115) which are each separate from each other such that each shim block (101, ...,115) may be individually inserted into a shim opening (9) of a magnetic field-generating unit (2) of the magnetic resonance apparatus (1), wherein each shim block (101, ...,115) comprises an amount of shim iron (10), and the set comprises at least two shim blocks (101, ...,115) for which the respective amount of the shim iron (10) is different from each other. In this way, the shimming procedure may be simplyfied and the shim capacity may be increased to a high pultrusion volume.

## Description

### FIELD OF THE INVENTION

The invention relates to the field of shim blocks for use with a magnetic resonance (MR) apparatus.

### BACKGROUND OF THE INVENTION

In nuclear magnetic resonance (NMR) and magnetic resonance imaging (MRI), shimming is used prior to the operation of the magnet to eliminate inhomogeneities in its static magnetic field. Initially, the magnetic field inside an NMR spectrometer or MRI scanner is far from homogeneous compared with an "ideal" field of the device. This is a result of production tolerances and of the environment of the scanner. Iron constructions in the walls and the floor of the examination room become magnetized and disturb the field of the scanner. The sample or the patient become slightly magnetized when brought into the strong magnetic field and create additional inhomogeneous fields. The process of correcting for these inhomogeneities is called shimming the magnet, shimming the probe or shimming the sample, depending on the assumed source of the remaining inhomogeneity. Field homogeneity of the order of 1 ppm over a volume of several liters is needed in an MRI scanner. High-resolution NMR spectroscopy demands field homogeneity better than 1 ppb within a volume of a few milliliters.

In general, there are two types of shimming: active shimming and passive shimming. Active shimming uses coils with adjustable current. Passive shimming involves pieces of iron with suitable magnetic properties, also called shim irons. The shim irons are placed near the permanent or superconducting magnet. They become magnetized and produce their own magnetic field. In both cases, the additional magnetic fields from the coils or shim irons, respectively, add to the overall magnetic field of the superconducting magnet in such a way as to increase the homogeneity of the total field.

Typically, a MRI scanner comprises a field-generating unit (both B0 + gradients), which has shim openings along the longitudinal axis into which shim rails are inserted. Typically, the number of such shim openings is 12 to 24. The shim rails have various pockets into which shim irons are placed. The number of such pockets is typically approx. 20. The number of shim irons placed in a respective pocket depends on the shimming requirements and is subject to the calculation of the required shimming in the course of the shimming procedure.

Inserting the shim irons into the pockets of the shim rails is error prone, since thousands of shim irons have to counted correctly, and even a correctly counted number of shim irons may be placed in a wrong pocket.

From US 2015/0362570 A1, a magnetic resonance imaging apparatus is known which includes a static field magnet, a gradient coil and a shim housing box. The static field magnet generates a static magnetic field in a space within a substantially cylindrical hollow. The gradient coil is provided inside the static field magnet and generates a gradient magnetic field. The shim housing box is capable of housing a metallic shim, the shim housing box being formed into a shape such that an attractive force of the static magnetic field applied to the shim housing box under magnetic excitation becomes smaller than a predetermined threshold.

### SUMMARY OF THE INVENTION

It is an object of the invention to simplify the shimming procedure and to increases the shim capacity to a high pultrusion volume.

According to the invention, this object is addressed by the subject matter of the independent claims. Preferred embodiments of the invention are described in the sub claims.

Therefore, according to the invention, a set of shim elements for use with a magnetic resonance apparatus is provided, wherein
the shim elements comprise shim blocks which are each separate from each other such that each shim block may be individually inserted into a shim opening of a magnetic field-generating unit of the magnetic resonance apparatus,
each shim block comprises an amount of shim iron, and
the set comprises at least two shim blocks for which the respective amount of shim iron is different from each other.

Hence, according to the invention, multiple separate shim blocks are used which preferably completely fill the pultrusion of a shim opening together. The shim blocks preferably sit back to back with no distance from each other. In this way, motion is already largely prohibited by the surrounding pultrusion, but additional interlocking features could be implemented as explained more in detail further below.

The shim opening is typically a channel into which the shim elements may be inserted one after the other.

In conventional systems, typically a certain number of identical shim irons are placed in the pockets of the shim rails. According to the invention, it would also be possible to provide different shim blocks with a different number of identical shim irons. However, the invention only requires that the amount of shim iron is different for different shim blocks.

Therefore, it is also possible to place a single shim iron in each shim block, wherein different shim irons are different from each other in that they each provide a different amount of shim iron. According to an embodiment of the invention, the amount of shim iron in each shim block is provided by a number of shim iron plates which all have the same weight and/or dimensions. In this way, only one single type of shim iron plates must be provided which makes manufacturing and storage of such shim iron plates simple and easy.

In general, the respective shim elements do not have to have the same shape. However, according to an embodiment of the invention, the shim elements all have the same outer shape, wherein the volume of each shim element which is not filled with shim iron is made from a magnetically passive material. In this way, a set of shim elements may be provided which is comprised of multiple different shim blocks which, for a certain shimming area, have a certain respective shimming potency which depends on the amount of shim iron of each respective shim block.

Further, the shim elements may be designed in different ways and may have different types of outer shapes. However, according to an embodiment of the invention, the outer shape of the shim elements is such that two respective shim elements may be connected to each other by form fit. Such form fit may be achieved by openings and protrusions with shapes which are congruent to each other, like respective studs and dimples of a Lego^{®} brick. Further, according to an embodiment of the invention, the shim elements are each provided with interlockings such that respective two shim elements may be interlocked to each other via these interlockings which even allows that such interlocked shim elements may be pulled out together by pulling just on one shim element.

In general, the shim iron may be arranged inside the shim block in different ways. According to an embodiment of the invention, the shim iron is arranged inside each shim block such that a part of the shim iron forms an outer surface of the shim block or lies directly next to an outer surface of the shim block. In case of multiple shim irons for a shim block this means that a first shim iron forms an outer surface of the shim block or lies directly next to an outer surface of the shim block, and that a second shim iron is directly stacked on the first shim iron, a third shim iron is directly stacked on the second shim iron and so on. This leads to an asymmetric design which allows for changing the shim potency of a shim block by turning it upside down by 180° in the shim opening of a respective MR apparatus such that the shim iron of a respective shim block is arranged nearer to or farther away from the axis of the bore of an MR apparatus, respectively.

According to a preferred embodiment of the invention, the shim elements comprise at least one dummy block which is separate from all shim blocks of the set such that also the dummy block may be individually inserted into a shim opening of a magnetic field-generating unit of a magnetic resonance apparatus, wherein the dummy block is free of any shim iron. Such a dummy block has a shimming potency of essentially 0 and, in this way, completes the set of shimming elements. Preferably, the shape of the dummy block is the same as the shape of the shim blocks or the dummy block has half of the length of the shim blocks.

It is further preferred that each shim element comprises an indication on its outside which indicates the amount of shim iron comprised by the respective shim element. This simplifies the use of the different shim elements and arranging them in a shim opening.

Further, according to the invention, a magnetic resonance apparatus with a bore for accommodating a subject under examination and a magnetic field-generating unit surrounding the bore is provided, wherein the field-generating unit comprises a plurality of shim openings which run parallel to the longitudinal axis of the bore and wherein at least one of the plurality of shim openings comprises a set of shim elements as described above.

According to an embodiment of the invention, all shim openings are completely filled with a respective set of shim elements. In case very little shimming is required such a set comprises a high number of dummy blocks or a large number of blocks with little shim material content.

It is further preferred that the shim elements have a cross section which corresponds to the cross section of the shim openings. The term "corresponding cross sections" is to be understood such that the shim elements have a just slightly smaller cross section than the shim openings such that they still fit into the shim openings, i.e. by a tight fit, and can be inserted into and removed from the shim openings by hand, respectively.

According to an embodiment of the invention, the shim elements are connected to each other by a detachable string and/or the shim elements 100, ...,115 are wrapped into a sleeve 15. Such a string allows for pulling the shim elements out of a shim opening which only comprises one open end. Wrapping the blocks in a sleeve may facilitate gliding the shim elements into the shim openings and/or compensate cross-sectional tolerances in the shim openings.

Furthermore, according to the invention, a method of shimming a magnetic resonance apparatus which comprises a magnetic field-generating unit with multiple shim openings is provided, comprising the following method steps:
providing a set of shim elements as described above,
lining up the shim elements according to an order which has been determined beforehand under shimming requirement for the magnetic imaging apparatus, and
inserting the lined-up shim elements in their beforehand-determined order into a respective shim opening one after the other.

Preferably, the shim elements are connected to each other by a string before insertion into the shim opening. Further, it is preferred that the shim elements are wrapped into a sleeve before insertion into the shim opening.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 a magnetic resonance apparatus according to an embodiment of the invention
Fig. 2. schematically depicts a magnetic field-generating unit with shim openings according to an embodiment of the invention
Fig. 3 a set of shim elements according to an embodiment of the invention
Fig. 4a schematically depicts two shim elements according to an embodiment of the invention
Fig. 4b schematically depicts two shim elements according to an embodiment of the invention, and
Fig. 4c depicts a shim element and a sleeve according to an embodiment of the invention.

### DETAILED DESCRIPTION OF EMBODIMENTS

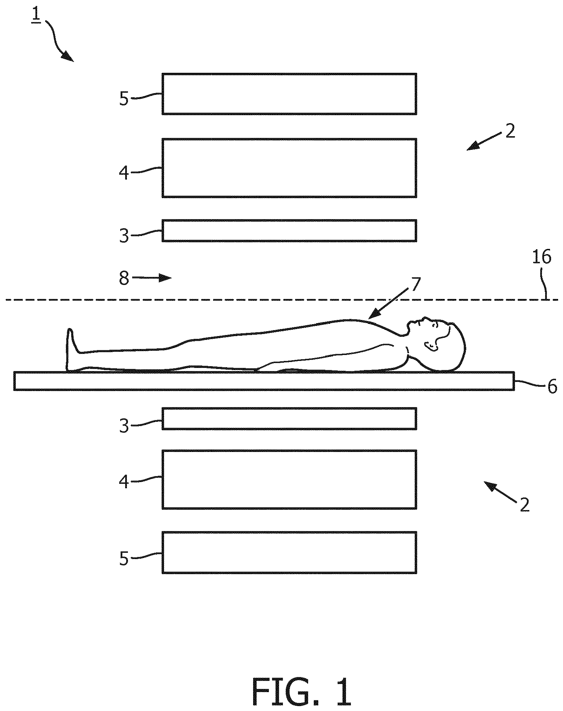

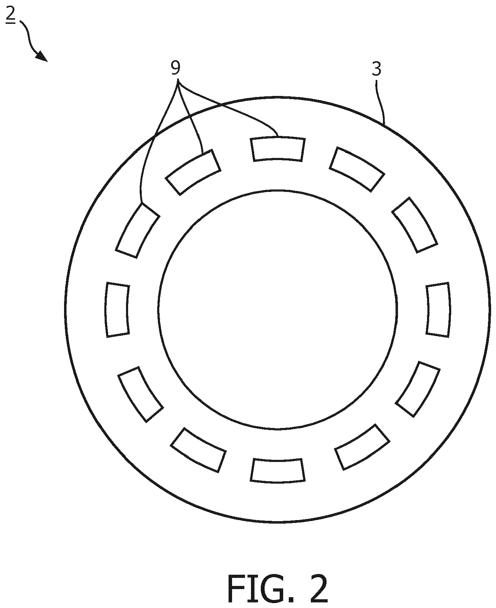

Fig. 1 schematically depicts a cross-sectional view of a magnetic resonance apparatus 1 with a bore 8 for accommodating a subject under examination 7 who is arranged on a patient support 6 and a magnetic field-generating unit 2 surrounding the bore 8. The magnetic field-generating unit 2 comprises a RF coil 3, a gradient coil 4 and a static field magnet 5. As can be seen from Fig. 2 which shows a view onto the RF coil 3 along the longitudinal axis 16 of the bore 9, the field-generating unit 2 comprises a plurality of shim openings 9 which run parallel to the longitudinal axis 16 of the bore 9. In these shim openings 9 multiple shim elements 100, ...,115 may be inserted. Such shim elements 100, ...,115 allow for shimming according to shimming requirements which are subject to the calculation of a required shimming in the course of the shimming procedure beforehand.

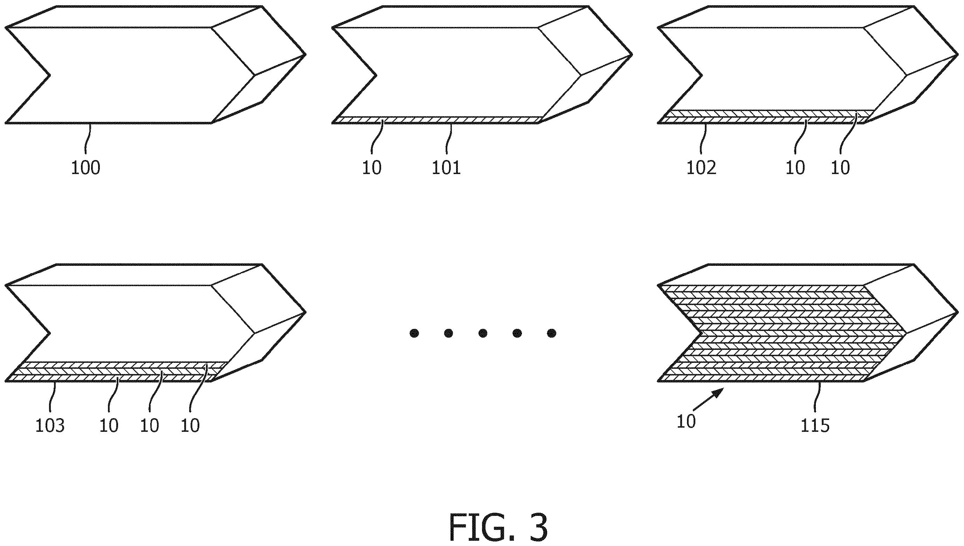

According to an embodiment of the invention, for such shimming, a set of shim elements 100, ...,115 is provided which comprises 16 different shim elements 100, ...,115 and multiple of each of the 16 different shim elements 100, ..., 115, respectively. This is schematically depicted in Fig. 3 which shows the 16 different types of shim elements 100, ...,115. The shim elements 100, ...,115 comprise a dummy block 100 with no shim iron at all and shim blocks 101, ..., 115 which differ in their amount of shim iron 10. The part of the shim elements 100, ...,115 which is not made from shim iron is made from a magnetically passive material, e.g. a plastic material. Of course, other numbers of different shim elements would be possible, e.g. 21 different shim elements with one dummy block and 20 shim blocks with different amounts of shim iron, respectively. For easy handling, each shim element 100, ...,115 may comprise an indication on its outside which indicates the amount of shim iron comprised by the respective shim element 100, ...,115. All shim elements 100, ...,115 have a cross section which corresponds to the cross section of the shim openings 9 which means that the shim elements 100, ..., 115, when inserted into a shim opening 9 have a tight fit, while they can still be removed from the shim opening 9 by hand.

Though the shim iron in each shim block 101, ... 115 could be provided as a single shim iron block for each shim block 101, ... 115, according to the embodiment of the invention described here, the amount of shim iron in each shim block 101, ...,115 is provided by a number of shim irons 10 which all have the same weight and/or dimensions which is also depicted in Fig. 3. From Fig. 3 it can also be understood that the shim blocks 101, ...,115 all have the same outer shape, and wherein the volume of each shim block 100, ...,115 which is not filled with shim iron 10 is made from a magnetically passive material as mentioned above. The outer shape of the shim elements 100, ..., 115 is such that two respective shim elements 100, ...,115 may connected to each other by form fit. Here, the outer shape is such that two respective shim elements 100, ...,115 may connected to each other by form fit.

A further advantage of the embodiment of the invention described here lies in the fact that the shim iron 10 is arranged inside each shim block 101, ...,115 such that a part of the shim iron 10 forms an outer surface of the shim block 101, ...,115. In the present case this means that a first shim iron 10 forms an outer surface of the shim block 10, and that a second shim iron 10 is directly stacked on the first shim iron 10, a third shim iron 10 is directly stacked on the second shim iron 10 and so on. In this way, an asymmetric design is achieved, which allows for changing the shim potency of a shim block 101, ...,115 by turning it upside down by 180° in the shim opening 9 of the MR apparatus 1 such that the shim iron of a respective shim block 101, ..., 115 is arranged nearer to or farther away from the longitudinal axis 16 of the bore 8 of the MR apparatus 1, respectively.

In this way, each shim opening 9 may be filled with a subset of shim elements 100, ...,115 chosen according to the beforehand calculated shimming requirements. The respective shim elements 100, ...,115 may be individually inserted into a shim opening 9 of a magnetic field-generating unit 2 of the magnetic resonance apparatus 1.

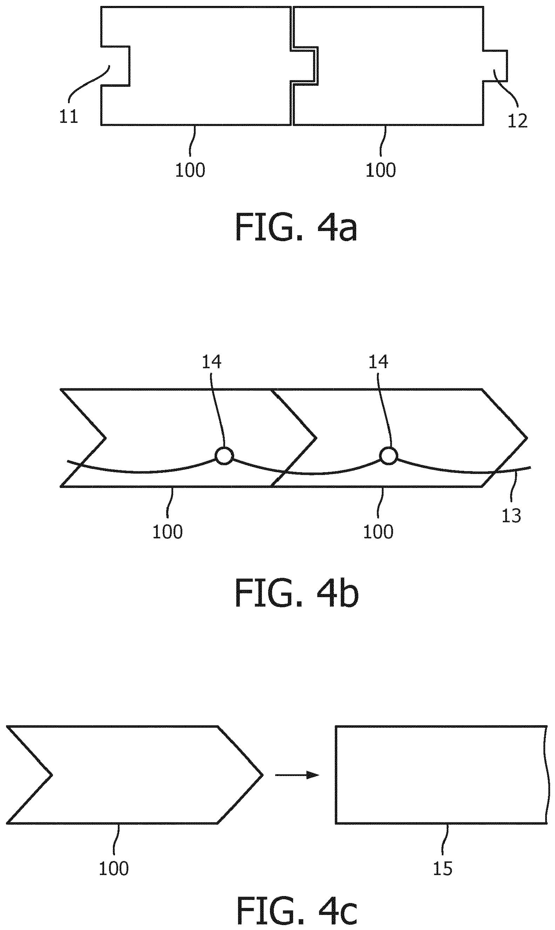

As depicted in Fig. 4a, according to an embodiment of the invention, the outer shape of the shim elements 100, ...,115 is such that two respective shim elements 100, ...,115 may be connected to each other by form fit. In this respect, the shim blocks 100 shown in Fig. 4a are provided with openings 11 and corresponding protrusions 12, respectively, on opposite sides.

Further, according to another embodiment depicted in Fig. 4b, the shim elements 100, ...,115 are connected to each other by a detachable string 13 which allows for pulling the shim elements 100, ...,115 out of a shim opening 9 which only comprises one open end.

Further, as depicted in Fig. 4c, according to an embodiment of the invention, the shim elements 100, ...,115 are wrapped into a sleeve 15. Wrapping the shim elements 100, ...,115 into a sleeve 15 facilitates gliding the shim elements 100, ...,115 in the shim opening 9 and further compensates tolerances of the cross section of a shim opening 9.

Irrespective of whether the shim elements 100, ...,115 are wrapped in a sleeve or not, according to an embodiment of the invention, for installing the shim elements 100, ...,115 in a shim opening, they are lined up according to an order which has been determined beforehand under shimming requirements for the magnetic imaging apparatus 1, and then the lined-up shim elements 100, ...,115 are inserted in their beforehand-determined order into the respective shim opening 9 one after the other.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

- magnetic resonance apparatus: 1
- magnetic field-generating unit: 2
- RF coil: 3
- gradient coil: 4
- static field magnet: 5
- patient support: 6
- subject under examination: 7
- bore: 8
- shim openings: 9
- shim irons: 10
- dummy block: 100
- shim blocks: 101, ...,115
- openings: 11
- protrusions: 12
- string: 13
- attachment means: 14
- sleeve: 15
- longitudinal axis of the bore: 16

## Claims

1. A set of shim elements (100, ...,115) for use with a magnetic resonance apparatus (1), wherein
the shim elements (100, ...,115) comprise shim blocks (101, ...,115) which are each separate from each other such that each shim block (101, ...,115) may be individually inserted into a shim opening (9) of a magnetic field-generating unit (2) of the magnetic resonance apparatus (1),
each shim block (101, ...,115) comprises an amount of shim iron, and
the set comprises at least two shim blocks (101, ...,115) for which the respective amount of shim iron (10) is different from each other.

2. The set of shim elements (100, ...,115) according to claim 1, wherein the amount of shim iron in each shim block (101, ...,115) is provided by a number of shim iron plates (10) which all have the same weight and/or dimensions.

3. The set of shim elements (100, ...,115) according to claim 1 or 2, wherein the shim elements (100, ...,115) all have the same outer shape, and wherein the volume of each shim element (100, ...,115) which is not filled with shim iron is made from a magnetically passive material.

4. The set of shim elements (100, ...,115) according to claim 3, wherein the outer shape is such that two respective shim elements (100, ...,115) may be connected to each other by form fit.

5. The set of shim elements (100, ...,115) according to any of the previous claims, wherein the shim elements (100, ...,115) are each provided with interlockings such that respective two shim elements (100, ...,115) may be interlocked to each other via these interlockings.

6. The set of shim elements (100, ...,115) according to any of the previous claims, wherein the shim iron is arranged inside each shim block (101, ...,115) such that
a part of the shim iron (10) forms an outer surface of the shim block (101, ...,115) or lies directly next to an outer surface of the shim block (101, ...,115).

7. The set of shim elements (100, ...,115) according to any of the previous claims, wherein
the shim elements (100, ...,115) comprise at least one dummy block (100) which is separate from all shim blocks (101, ...,115) of the set such that also the dummy block (100) may be individually inserted into a shim opening (9) of a magnetic field-generating unit (2) of the magnetic resonance apparatus (1), wherein the dummy block (100) is free of any shim iron.

8. The set of shim elements (100, ...,115) according to any of the previous claims, wherein each shim elements (100, ...,115) comprises an indication on its outside which indicates the amount of shim iron comprised by the respective shim element (100, ...,115).

9. A magnetic resonance apparatus (1) with a bore (8) for accommodating a subject under examination (7) and a magnetic field-generating unit (2) surrounding the bore (8), wherein the field-generating unit (2) comprises a plurality of shim openings (9) which run parallel to the longitudinal axis (16) of the bore (9) and wherein at least one of the plurality of shim openings (9) comprises a set of shim elements (100, ...,115) according to any of claims 1 to 8.

10. The MR apparatus (1) according to claim 8, wherein all shim openings (9) are completely filled with a respective set of shim elements (100, ...,115) according to any of claims 1 to 8.

11. The MR apparatus (1) according to claim 9 or 10, wherein the shim elements (100, ...,115) have a cross section which corresponds to the cross section of the shim openings (9).

12. The MR apparatus according to any of claims 9 to 11, wherein the shim elements (100, ...,115) are connected to each other by a detachable string (13) and/or wherein the shim elements (100, ...,115) are wrapped into a sleeve (15).

13. A method of shimming a magnetic resonance apparatus (1) which comprises a magnetic field-generating unit (2) with multiple shim openings (9), comprising the following method steps:
providing a set of shim elements (100, ...,115) according to any of claims 1 to 7,
lining up the shim elements (100, ...,115) according to an order which has been determined beforehand under shimming requirement for the magnetic imaging apparatus (1), and
inserting the lined-up shim elements (100, ...,115) in their beforehand-determined order into a respective shim opening (9) one after the other.

14. The method according to claim 13, wherein the shim elements (100, ...,115) are connected to each other by a string (13) before insertion into the shim opening (9).

15. The method according to claim 13 or 14, wherein the shim elements (100, ...,115) are wrapped into a sleeve (15) before insertion into the shim opening (9).
